# FASCICULE DE BREVET EUROPEEN

(11) **EP 2 421 350 B1**
(45) Date de publication et mention de la délivrance du brevet: **30.09.2015**
(21) Numéro de dépôt: 11176995.6
(22) Date de dépôt: 09.08.2011
(51) Int. Cl.: H05K 7/20

(54) **Equipement électrique à refroidissement fluide, baie avionique pour recevoir un tel équipement et aéronef équipé de telles baies**
Elektrogerät zur Fluidabkühlung, Ausbuchtung im Luftfahrzeug zur Aufnahme eines solchen Geräts und mit solchen Ausbuchtungen ausgestattetes Luftfahrzeug
Electric device with fluid cooling, avionics rack for receiving such a device and aircraft provided with such racks

(30) Priorité: 19.08.2010 FR 1056683
(43) Date de publication de la demande: 22.02.2012
(73) Titulaire: Airbus Operations, 31060 Toulouse (FR)
(72) Inventeur: Caron, Jean-Christophe, 31490 Leguevin (FR); Mairet, Philippe, 31400 Toulouse (FR); Rebeyrotte, Vincent, 31770 Colomiers (FR); Roujean, Olivier, 31770 Colomiers (FR)
(74) Mandataire: Santarelli

(56) Documents cités:
- US-A- 5 177 666
- US-A- 5 348 482
- US-A1- 2009 260 777

## Description

La présente invention concerne un équipement électronique à refroidissement fluide, une baie avionique pour recevoir un tel équipement et un aéronef équipé de telles baies.

Dans l'état de la technique, on connaît des équipements électroniques montés dans des baies avioniques. Un équipement électronique comprend dans un conditionnement souvent métallique, dit aussi carter, enveloppe, carrosserie ou « packaging », un ensemble de cartes électroniques dissipatrices de chaleur. Une baie avionique est une structure mécanique de type « étagère » conçue pour accueillir les divers équipements électroniques prévus pour faire fonctionner l'avion et ses services. La baie avionique permet de connecter mécaniquement et électriquement un ou plusieurs équipements électriques de manière amovible aux divers réseaux embarqués, réseau de communication, de distribution d'énergie, de contrôle, etc. de l'avion.

Une norme existe pour ce type d'appareil, la norme ARINC 600, dans laquelle est spécifiée la dimension des équipements électroniques insérés dans la baie avionique. Dans chaque étage de la baie avionique se trouve insérée une veine d'air de refroidissement produite en ventilation forcée.

Une telle veine de ventilation forcée est produite par un système de production d'air sous pression qui permet de refroidir par de l'air frais les divers équipements électriques. Elle est installée entre l'étagère proprement dit et une chaise d'adaptation électrique et mécanique fixée à demeure sur l'étagère par deux rives de celle-ci.

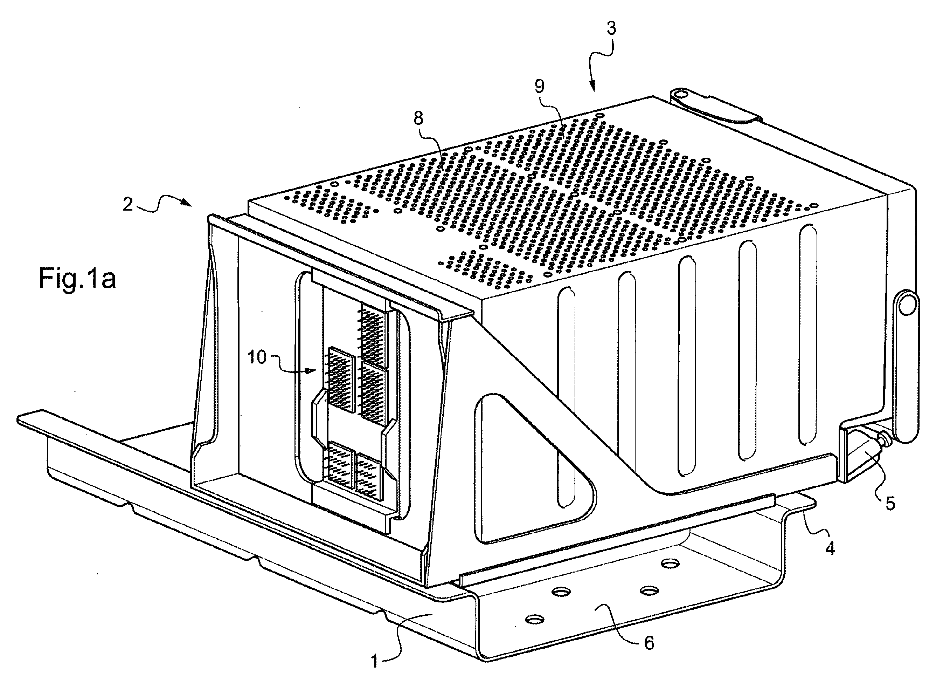

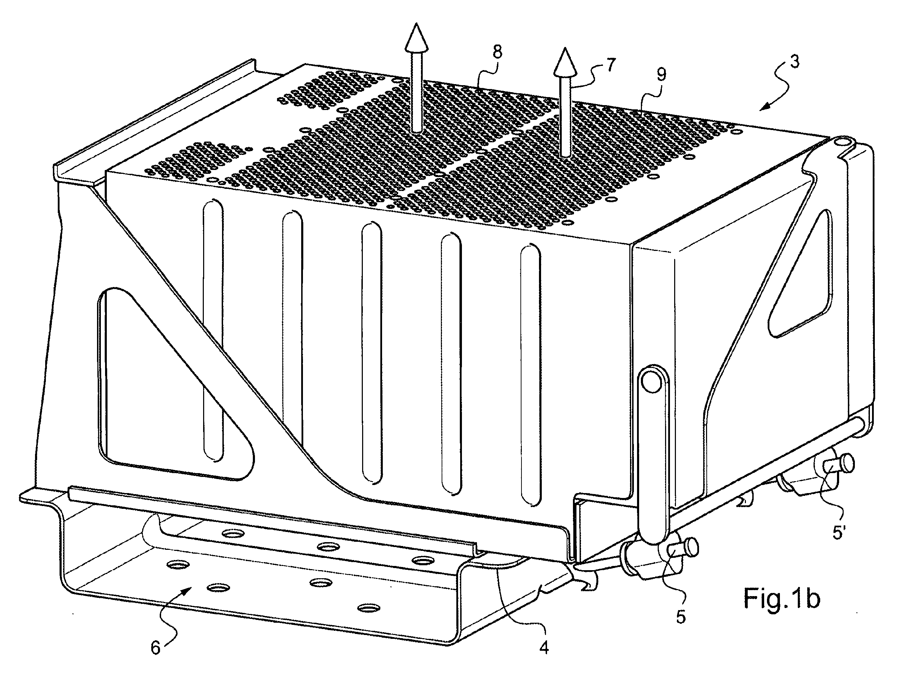

Aux figures 1a et 1b, on a représenté deux vues en perspective d'un équipement électronique inséré sur une chaise d'adaptation mécanique et électrique, montée sur une étagère 1. Plusieurs équipements électriques peuvent ainsi être disposés, chacun sur une chaise d'adaptation électrique et mécanique, le long de l'étagère. La baie avionique peut comporter plusieurs étagères les unes au dessus des autres.

La chaise d'adaptation électrique et mécanique 2 est posée transversalement à la direction de l'étagère, sur celle-ci. La chaise 2 est fixée à l'étagère 1 par des vis (non représentées). La chaise 2 présente une partie verticale qui porte la connectique spécifique à l'avion 10 et une partie horizontale posée sur des rives 4 de l'étagère 1.

L'équipement électrique 3 est installé par insertion dans la chaise d'adaptation électrique et mécanique 2 et y est fixé de manière amovible à l'aide de vis 5 et 5' qui, d'une part, solidarisent l'équipement électrique dans la chaise et, d'autre part, procurent un mouvement de translation oblique de façon à assurer une connexion de la connectique propre à l'équipement électronique 3 sur la connectique spécifique avion 10 sur la chaise 2 d'adaptation électrique et mécanique.

Lorsque, pour la réparation, on souhaite retirer l'équipement électronique 3, il suffit de dévisser les vis 5 et 5' et de retirer l'équipement électronique 3.

Lorsque le système de production d'air sous pression est connecté au profilé de l'étagère, une veine d'air sous pression 6 traverse l'espace compris entre les ailes du profilé de l'étagère 1 et le carter qui entoure l'équipement électronique 3. Des trous sur le socle du conditionnement ou carter de l'équipement électronique 3 et en regard de trous sur la partie horizontale de la chaise 2 mettent en communication l'intérieur de l'équipement électronique 3 et la veine d'air 6.

De l'air est alors prélevé sur la veine 6, traverse le volume de l'équipement électronique au droit de la prise d'air ainsi formée sur la veine d'air et ressort par des orifices 8 et 9 selon un flux d'air réchauffé 7 qui se mélange à l'air ambiant de la baie avionique.

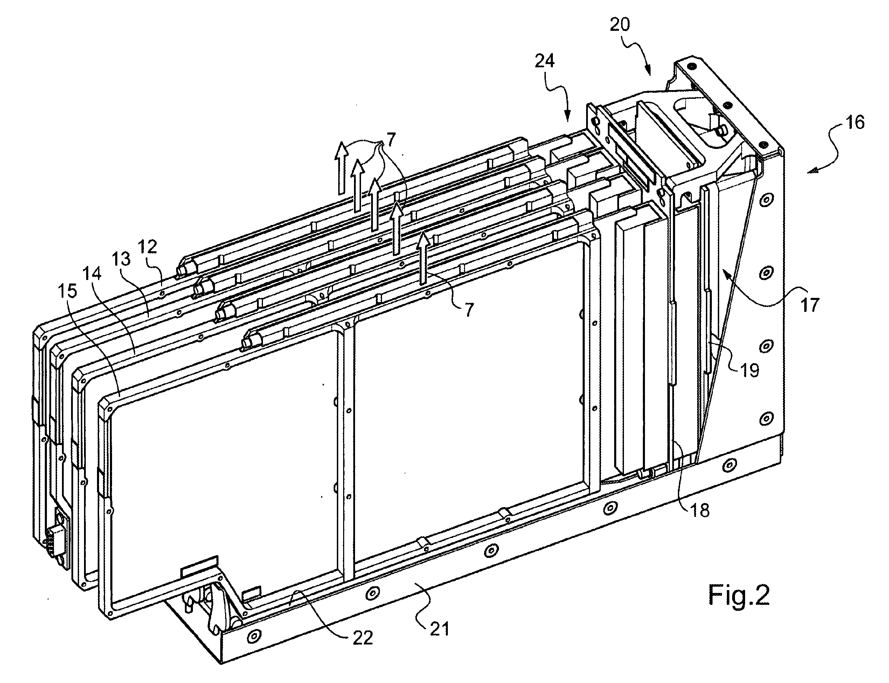

A la Figure 2, on a représenté un exemple de réalisation de l'état de la technique. Dans le système mis en oeuvre selon la norme ARINC 600, l'équipement électronique amovible présente, à la Figure 2, un socle 21 du conditionnement portant un support porte-glissières 22 dans chacune desquelles est insérée une carte électronique 12 à 15.

Chaque carte est disposée verticalement et présente un bord latéral, à droite à la Figure 2, qui vient s'engager dans des connecteurs appartenant au fond de panier 20 comme le connecteur 24.

Le fond de panier 20 peut comporter plusieurs cartes de fond de panier 18, 19. Le fond de panier 20 présente par ailleurs, vers l'arrière à la figure 2, des connecteurs 17 qui sont destinés à venir s'engager dans la connectique avionique (Figure 1a) sur la chaise 2 d'adaptation électrique et mécanique (Figures 1a et 1b).

Le flux d'air ventilé prélevé sur la veine d'air 6 passe entre les cartes selon le flux d'air 7 à la figure 2.

Ce principe de refroidissement par air s'avère insuffisant pour réguler la température de certains composants électriques implantés sur certaines cartes électroniques.

On s'est en effet aperçu que la densité de puissance augmente sans cesse alors que la température admissible de ces composants tend à décroitre avec l'augmentation de la vitesse d'horloge.

Ainsi, le refroidissement par air soufflé, mis en oeuvre notamment selon la norme ARINC 600, présente notamment des limitations dans les cas suivants :
- lorsque localement la puissance dissipée est trop importante parce qu'un composant électronique est fortement dissipatif ;
- lorsqu'il y a dépressurisation de la soute avionique, voire une perte totale de la ventilation par l'avion.

Dans de telles situations, le contrôle thermique de la baie avionique exigerait :
- des systèmes de refroidissement massifs et encombrants, incompatibles avec les contraintes d'intégration avionique ou
- une infaisabilité du refroidissement aéraulique de l'équipement électrique :
- un non respect des températures maximum admissibles par les composants et les matériaux de l'équipement électrique, notamment entrainant un risque de dégradation physique irréversible ;
- une réduction significative des fonctionnalités électriques et logicielles de l'équipement électrique installé et refroidi ;
- une baisse de la fiabilité d'ensemble puisqu'une augmentation de la température engendre une baisse de la durée de vie de l'équipement électrique refroidi.

Par ailleurs, la conception d'un équipement avionique est souvent issue d'un compromis avec au moins l'une des contraintes suivantes :
- un faible encombrement supplémentaire dans l'équipement électrique de la baie avionique ;
- le respect d'un pas inter-carte entre deux cartes consécutives dans l'équipement électrique ;
- le respect d'une double remplaçabilité des cartes dans l'équipement électrique d'une part et de chaque équipement électrique sur l'étagère, d'autre part ;
- le maintien d'un refroidissement efficace de composants fortement dissipatif lors des pannes de pressurisation de l'avion ou de pannes totales de ventilation ; et
- la réduction de la masse de l'équipement avionique de façon à respecter le problème général dans lequel toute nouvelle implantation doit se traduire par des coûts d'exploitation limités.

US 2009/260777 divulgue un équipement électronique selon la première partie de la revendication 1.

A cet effet, la présente invention vise à remédier à au moins un des inconvénients précités. Elle concerne un équipement électronique comportant un conditionnement et contenant au moins une carte électronique dissipatrice de chaleur et connectée électriquement à un ensemble de fond de panier. L'équipement électronique de l'invention comporte au moins une entretoise solidaire du fond de panier qui porte des raccords fluidiques rapides pour le raccord à un réseau de fluide de refroidissement extérieur audit équipement, lesdits raccords fluidiques rapides étant accessibles de l'extérieur de la carrosserie, et au moins un trajet de collecte de chaleur sur ladite au moins une carte électronique étant connecté fluidiquement auxdits raccords fluidiques rapides, la carte étant équipée d'au moins une plaque métallique collectrice de chaleur qui porte des raccords fluidiques rapides de carte, respectivement d'entrée et de sortie de fluide de refroidissement, qui se connectent avec lesdits raccords fluidiques rapides et établissent ainsi un circuit fluidique de refroidissement avec le réseau de fluide de refroidissement.

Un avantage de cette disposition est que l'équipement électrique et ses cartes électroniques peuvent être refroidis par du fluide de refroidissement extérieur tout en permettant que l'équipement puisse être démonté et remonté sur le réseau de fluide de refroidissement extérieur au dit équipement.

En outre, la présence d'une plaque collectrice de chaleur portant les raccords permet de réduire le nombre de ces derniers et le nombre de connexions du réseau de fluide de refroidissement.

En particulier, grâce à cette disposition il est possible, avec seulement deux raccords rapides, de desservir l'ensemble des composants de la carte afin de les refroidir.

Selon d'autres caractéristiques avantageuses :
- ladite au moins une carte électronique porte au moins une plaque collectrice de chaleur parcourue par des canaux de circulation de fluide connectés par des raccords fluidiques rapides de plaque à des raccords fluidiques rapides correspondants solidaires de ladite au moins une entretoise, les raccords fluidiques rapides de ladite au moins une entretoise étant interconnectés par l'intermédiaire d'une chambre de distribution, ladite au moins une carte pouvant être amovible sur la glissière d'un support porte-glissières ; un avantage de cette disposition est de permettre à la fois le refroidissement fluidique au moyen de la plaque de collecte de chaleur et un démontage et un remontage de la carte électronique dans l'équipement ;
- la plaque collectrice de chaleur comporte une plaque usinée de formes générales adaptées aux zones thermiques de la carte électronique et des canaux de circulation de fluide connectées auxdits raccords fluidiques rapides de plaque, la plaque usinée étant fermée par un couvercle dont la liaison à la plaque usinée est rendue étanche par une soudure ; un avantage de cette disposition est de permettre une réalisation selon un procédé de fabrication éprouvée des plaques collectrices de chaleur ;
- la plaque usinée et/ou le couvercle sont réalisés en un matériau choisi parmi les matériaux de faible densité et de forte conductivité et capacité thermique, préférentiellement de l'aluminium ; un avantage de cette disposition est de minimiser la masse totale ajoutée par la solution de l'invention et de maximiser l'efficacité du drainage thermique.
- l'équipement comporte deux entretoises solidaires du dit ensemble de fond de panier comportant au moins une carte mère qui comporte des connecteurs pour s'engager avec des connecteurs de cartes électroniques et des connecteurs pour la connexion avec un réseau électrique extérieur à l'équipement, une première entretoise étant disposée d'un côté pour le circuit d'arrivée de fluide de refroidissement et une seconde entretoise étant disposée du côté opposé pour le circuit de retour sur l'ensemble de fond de panier ; un avantage de cette disposition est d'assurer une distribution de fluide de refroidissement à l'ensemble des cartes électroniques tout en formant un ensemble cohérent de fond de panier à demeure dans l'équipement électronique.

L'invention concerne aussi une baie avionique à refroidissement fluide pour équipement électronique amovible destinée à recevoir au moins un équipement électronique selon l'invention. Selon l'invention, chaque équipement électronique est relié de manière amovible par un réseau de tubulures à au moins une source froide d'un fluide de refroidissement.

Un avantage de cette disposition est d'assurer la double remplaçabilité d'une carte ou de l'équipement électronique dans le cadre d'un refroidissement extérieur par fluide.

Selon d'autres caractéristiques avantageuses :
- la baie étant du genre dans lequel au moins un équipement électronique est monté dans une chaise d'adaptation mécanique et électrique, chaque chaise d'adaptation porte des premiers raccords fluidiques rapides pour se raccorder aux tubulures du réseau de fluide de refroidissement, et des seconds raccords rapides reliés aux dits premiers raccords fluidiques rapides et qui fournissent une connexion fluidique amovible avec les raccords rapides de l'équipement lorsqu'il est retiré ou inséré de sa chaise d'adaptation dans la baie ; un avantage de cette disposition est d'assurer le montage ou le démontage d'un équipement électrique dans une baie dotée de chaises d'adaptation, tout en maintenant l'avantage du refroidissement fluide de chaque équipement électronique ;
- au moins un équipement électronique comporte un support porte-glissières muni de fentes dans au moins un espace inter-glissières, ledit au moins un équipement électronique amovible étant entouré d'un conditionnement dont au moins une face parallèle au support porte-glissières est munie de passages d'air, le refroidissement fluidique des cartes à l'intérieur de l'équipement amovible coopère avec un refroidissement par air forcé apporté par au moins une veine d'air circulant dans une étagère de la baie, la chaise d'adaptation mécanique et électrique, montée sur ladite étagère, comportant une zone de trous mettant en relation l'intérieur de l'équipement électronique avec ladite veine d'air à l'aide d'un joint qui limite une zone de pression entre la chaise et le support porte-glissières établissant un flux d'air de refroidissement entre les cartes ; un avantage de cette disposition est d'assurer le double refroidissement par air et par fluide de refroidissement extérieur, et ainsi de palier les défauts ou pannes de ventilation ou de dépressurisation de la soute avionique ;
- le fluide de refroidissement est de l'eau liquide.

L'invention concerne enfin un aéronef comportant une baie avionique selon l'invention.

Les avantages principaux de l'invention sont de permettre d'amener le liquide de refroidissement jusqu'à la chaise d'adaptation électrique et mécanique ARINC et de disposer d'une connectique hydraulique rapide qui permet, grâce à des raccords rapides adaptés, de déconnecter sous pression les différents organes mis en oeuvre dans le circuit de refroidissement tant de la carte électronique dissipatrice que de l'équipement lui-même lorsqu'il est déplaçable ou démontable de la chaise d'adaptation électrique et mécanique.

Par ailleurs, l'invention permet d'utiliser un cheminement fluidique spécifique pour transmettre le liquide de refroidissement jusqu'aux cartes électroniques de l'équipement.

L'invention permet enfin une circulation du liquide de refroidissement au plus près des composants électroniques qui présentent un caractère critique sur le plan thermique. Elle permet au liquide réchauffé de sortir des cartes, puis de l'équipement et enfin seulement de la chaise d'adaptation électrique et mécanique pour revenir vers la source de refroidissement.

D'autres caractéristiques et avantages de la présente invention seront mieux compris à l'aide de la description et des figures annexées qui sont :
- les figures 1a et 1b et 2 sont des vues en perspective de l'équipement électronique monté dans une chaise ainsi que des cartes électroniques dissipatrices montées dans un équipement électrique de manière amovible selon l'état de la technique ;
- la figure 3 est un schéma de principe du dispositif de l'invention ;
- la figure 4 est une vue en perspective schématique d'une partie d'une baie avionique selon un mode particulier de réalisation de l'invention ; et
- la figure 5 est une vue en perspective d'une chaise d'adaptation électrique et mécanique dans un mode particulier de réalisation de l'invention.

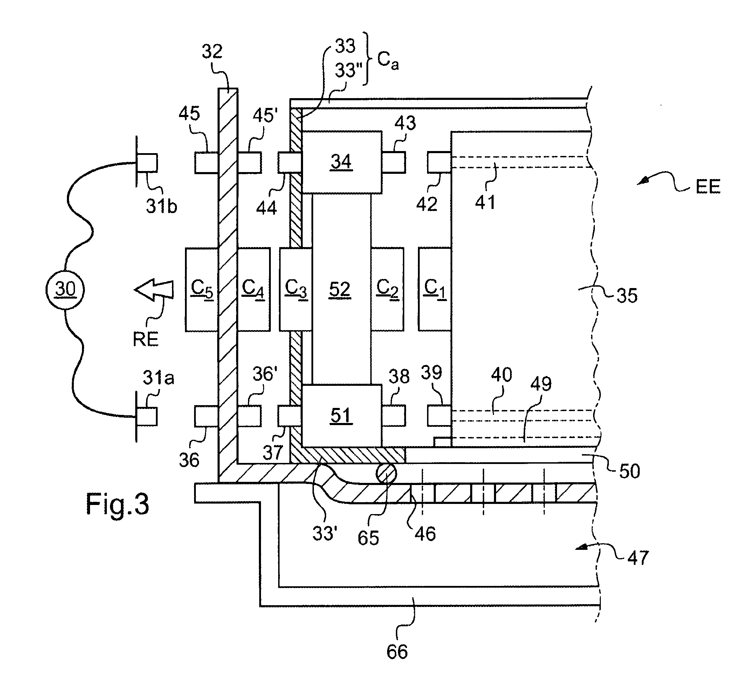

A la figure 3, on a représenté une vue schématique d'un mode de réalisation d'une partie d'une baie avionique selon l'invention embarquée à bord d'un aéronef. On y a représenté successivement de gauche à droite :
- la chaise d'adaptation électrique et mécanique 32 comportant une partie verticale portant dans sa partie centrale non représentée la connectique avionique et une partie horizontale qui vient en relation avec l'étagère 66 analogue à l'étagère 1 de la figure 1a ou 1b ;
- un conditionnement Ca d'équipement composé d'un couvercle 33" et d'un socle 33 avec une partie de support 33' d'un support porte glissières 49.

Plusieurs cartes électroniques dissipatrices de chaleur, comme la carte 35, sont insérées de manière amovible dans une glissière du support porte-glissières 49 par leur partie inférieure au dessin.

Chaque carte à refroidir comporte divers composants électroniques dissipatifs comme des microcontrôleurs, RAMs ou passifs comme des connecteurs. Une plaque métallique placée en couplage thermique au moins avec les composants les plus dissipateurs de chaleur est montée sur l'une ou l'autre des faces de la carte électronique. Dans la masse métallique de la plaque collectrice de chaleur sont aménagés des canaux dans lesquels circule le liquide de refroidissement, comme les canaux schématiquement indiqués par les tubes 40 et 41.

Les canaux débouchent sur un raccord fluidique rapide 39 d'arrivée d'un fluide de refroidissement et sur un raccord fluidique rapide 42 de retour de fluide de refroidissement après que celui-ci ait passé sur les différents composants par l'intermédiaire des canaux 40, 41 qui sont interconnectés.

Les raccords rapides 39 et 42 sont composés principalement chacun par un élément de raccord mâle ou femelle et par une valve, disposés en série, de sorte que dès que le raccord rapide est séparé de son raccord rapide d'accueil aucune fuite ne s'établisse entre les deux parties du circuit de refroidissement ouvert. Les raccords rapides d'entrée et de sortie sont connectés par l'intermédiaire de pièces fluidiques qui seront décrites ci-après à la tubulure d'un réseau de distribution du fluide de refroidissement dans la baie avionique. La tubulure, ou ensemble de canalisations ou de flexibles, est connectée à une source de fluide de refroidissement 30. La tubulure comporte un flexible aller 31a qui est mis en relation fluidique avec le raccord rapide d'entrée 39 de la carte 35 et un flexible de retour 31 b qui est mis en relation fluidique avec le raccord rapide de sortie 42 de la carte 35.

La carte 35 peut être connectée ou déconnectée de l'équipement électronique EE. A cette fin, les différents organes interposés entre les tubulures 31 a et 31 b de la baie avionique et les raccords rapides 42 et 39 de la carte électronique permettent une connexion/déconnexion de la carte électronique dans l'équipement EE, même lorsque le système de refroidissement est connecté.

A cette fin, la chaise d'adaptation électrique et mécanique 32 porte des paires de raccords rapides 45, 45' de sortie et 36, 36' d'entrée qui permettent un raccordement au flexible 31 b de retour pour le raccord rapide 45 et au flexible 31 a pour le raccord rapide 36.

Le raccord rapide 45 est connecté de manière convenable au raccord rapide 45'. Le raccord rapide 45' est disposé de l'autre côté de la partie verticale de la chaine 32 à l'intérieur de la chaise 32 en vis-à-vis de la partie verticale du socle 33. De même, le raccord rapide 36 est connecté par une tubulure convenable à un raccord rapide 36' en regard du socle 33.

Lorsque l'équipement électronique EE est inséré sur la chaise 32, les raccords rapides 44 et 45' se connectent ainsi que les raccords rapides 37 et 36', établissant ainsi un circuit fluidique de refroidissement avec la source froide 30.

De même, pour assurer une connexion protégée entre la carte 35 et les paires de raccords 44 et 37 du socle 33, il est prévu un raccord rapide 43 connecté par une tubulure convenable au raccord rapide 44 et un raccord rapide 38 connecté par une tubulure convenable au raccord rapide 37 sur le socle 33.

La connexion fluidique des raccords rapides 42 et 43, d'une part, et 39 et 38, d'autre part, assure une connexion amovible fluidique de la carte avec la source 30.

Dans un mode particulier de réalisation de l'invention, le socle 33 est équipé d'un fond de panier constitué entre deux entretoises supérieure 34 et inférieure 51 qui portent chacune les paires de raccords 44 et 43 pour le retour de fluide sur l'entretoise supérieure 34 et 37 et 38 pour l'arrivée de fluide sur l'entretoise inférieure 51.

Les cartes de fond de panier sont disposées à la figure 3 dans l'intervalle 52 entre l'entretoise supérieure 34 et l'entretoise inférieure 51.

Dans un mode de réalisation, chaque entretoise est munie de moyens de solidarisation de l'entretoise aux cartes de fond de panier 52 ainsi que les tubulures de connexion et les raccords rapides en paires 44, 43 d'une part et 37, 38 d'autre part.

Ainsi qu'il est par ailleurs connu, chaque carte électronique 35 est munie d'une connectique C1 de bord de carte. Le fond de panier 52 porte une connectique C2 adaptée pour recevoir la connectique C1 de chaque carte 35 insérée dans l'équipement électronique EE. Enfin la connectique C2 de fond de panier est électriquement reliée à une connectique C3, solidaire du fond de panier, et disposée en vis-à-vis d'une connectique C3 de la chaine d'adaptation électrique et mécanique 32. La connectique C4 de la chaise 32 est elle-même directement liée au réseau de câblage C5 de la baie avionique.

Cette disposition assure la double remplaçabilité d'une part, de l'équipement électronique EE sur la chaise d'adaptation électrique et mécanique 32 et, d'autre part, de chaque carte électronique, comme la carte 35, dans l'équipement EE.

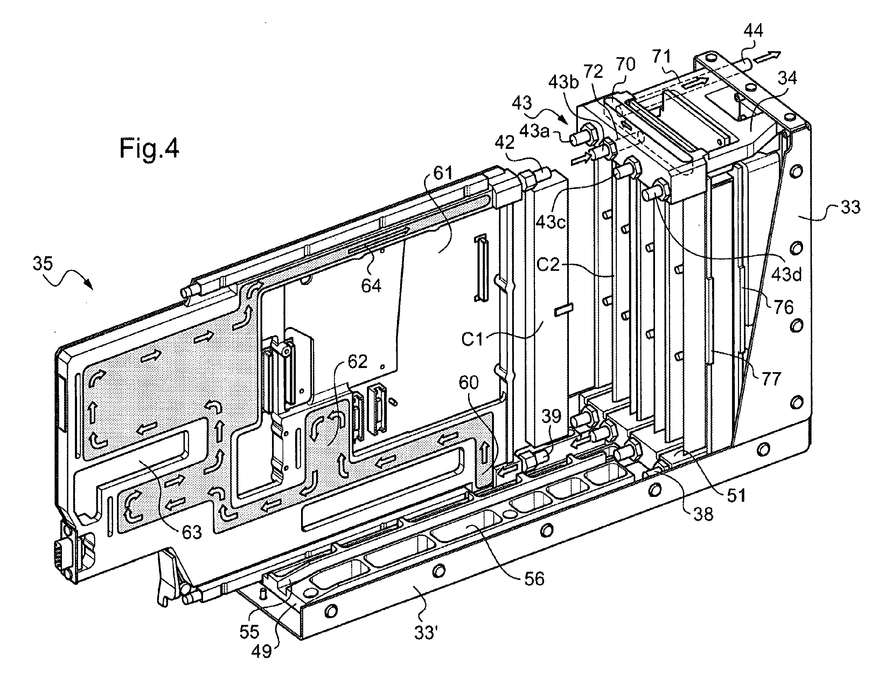

A la figure 4, on a représenté un mode particulier de réalisation d'un équipement électrique destiné à une baie avionique selon un mode particulier de réalisation de l'invention. A la figure 4, les mêmes éléments que ceux de la figure 3 portent les mêmes numéros de référence.

A la figure 4, le socle 33, 33' comporte une partie verticale 33 qui est destinée à venir en regard de l'intérieur de la partie verticale de la chaise 32 (Figure 3) tandis que la partie horizontale 33' du socle vient en relation avec la partie horizontale de la chaise 32.

A la figure 4, le socle est représenté avec l'ensemble de fond de panier et l'insertion en cours d'une carte à refroidir.

Le socle, dans sa partie horizontale 33', porte un support porte-glissières 49, 55, 56 qui présente, dans le mode de réalisation représenté, quatre glissières dans chacune desquelles est destinée à s'engager une carte électronique amovible comme la carte 35.

La carte 35 présente un bord inférieur longitudinal qui s'engage par glissement dans la glissière qui lui correspond sur le support porte-glissières 49 et un bord latéral, à droite à la figure 4, qui porte un connecteur de bord de carte C1.

Lorsque l'opérateur termine le mouvement d'insertion de la carte 35, le connecteur C1 s'engage sur le connecteur C2 réciproque de fond de panier.

Par ailleurs, la carte 35 est équipée d'une plaque de collecte de chaleur ou caloportrice 61-64 qui porte les raccords rapides 39 et 42 respectivement d'entrée et de sortie de fluide de refroidissement.

La plaque caloportrice 61-64 comporte des masses de stockage d'énergie thermique qui sont destinées à venir s'appliquer sur les composants électroniques les plus dissipateurs de chaleur et des évidements comme l'évidement 61 qui permettent d'équilibrer la dissipation de chaleur sur la carte et la plaque.

Un système de canaux, indiqués par les flèches 60, 62, 64, est établi dans la masse métallique de la plaque caloportrice. Le système de canaux apporte le fluide de refroidissement, apporté par les raccords rapides 39 et 42, au plus près des zones chaudes de la carte électronique 35. Le système de canaux réalise la fermeture du circuit fluidique de refroidissement entre les raccords rapides 39 et 42. Le système de canaux suit différents chemins dans l'épaisseur de la carte de façon à évacuer la chaleur dissipée par les composants électroniques thermiquement dissipatifs.

Dans un mode particulier de réalisation, la plaque collectrice de chaleur 61-64 contribue à accroître la rigidité mécanique de la carte électronique 35. A cette fin, dans un mode particulier de réalisation, la plaque collectrice de chaleur 61-64 est montée sur la plaque de circuit imprimé de la carte électronique 35 pour être à la fois en contact avec les composants électroniques les plus dissipateurs et avec des entretoises non représentées sur la carte électronique 35 et implantés de manière déterminée pour augmenter la rigidité mécanique de la carte électronique 35.

L'ensemble de ces dispositions d'une plaque de collecte de chaleur sur chaque carte électronique comme la carte 35 assure le respect d'un pas inter-carte entre deux cartes consécutives dans l'équipement en déterminant notamment le choix d'un matériau à forte capacité d'absorption thermique, un débit de fluide de refroidissement depuis la source froide (30 Figure 3), une longueur développée au plus proche des couplages thermiques avec les composants dissipateurs thermiques sur la carte électronique en même temps qu'un diamètre des canaux de refroidissement dans la plaque de collecte.

Par ailleurs, le choix d'une épaisseur de la plaque de collecte de chaleur et la disposition d'évidements 61, 63 dans cette plaque aux endroits moins producteurs de dissipation thermique de la carte électronique assure la minimisation de la masse de la solution apportée. Il faut en effet respecter les contraintes avioniques de réduction des masses embarquées dans le but de réduire les coûts d'exploitation de l'aéronef dans lequel l'équipement électrique de l'invention est embarqué.

Dans le mode de réalisation de la figure 4, un ensemble de fond de panier est prévu qui est solidaire de la partie verticale 33 du socle de l'équipement électrique.

Le fond de panier est compris entre deux entretoises respectivement 34 supérieure et 51 inférieure. Deux cartes de fond de panier respectivement 76 et 77 sont montées verticalement entre les deux entretoises 34 et 51, de manière à porter, d'une part, les connecteurs comme le connecteur C2 pour s'engager avec les diverses cartes électroniques, comme la carte 35, insérées dans l'équipement électronique, et, d'autre part, des connecteurs non visibles sur la partie droite de la figure 4 et qui s'engagent sur la connectique avionique 10 montée sur la chaise 2 (voir figure 1a).

On va maintenant détailler l'entretoise supérieure 34 qui est sensiblement identique à l'entretoise inférieure 51.

L'entretoise supérieure 34 est réalisée en un matériau plastique moulé et porte un raccord rapide 44 qui permet la connexion à un raccord rapide réciproque de la chaise 32, non représentée à la figure 4 (voir figure 3), et autant de raccords rapides qu'il est prévu de cartes électroniques comme les raccords rapides 43a-43d.

A la figure 4, la carte 35 est représentée en cours d'insertion et doit venir s'engager avec le raccord rapide 43b. Le raccord 43b est relié par une tubulure interne 72 à une chambre de répartition 70 qui est elle-même connectée au raccord rapide 44 par une tubulure 71.

De cette manière, il est possible de répartir l'ensemble des flux retour comme le flux revenant par le raccord rapide 43b vers le raccord rapide 44.

La même disposition est envisagée pour l'entretoise 51 d'arrivée de fluide de refroidissement.

Dans cette construction de baie avionique selon l'invention, il est possible grâce aux raccords rapides de déconnecter les tubulures comme les tubulures 31a et 31b (Figure 3) ou encore de déconnecter l'équipement électrique amovible complet en le retirant du socle 33, 33' ou encore en démontant l'une ou l'autre des cartes comme la carte 35. Grâce à ces dispositions de circuits fluidiques par des raccords rapides, on assure le respect d'une double remplaçabilité des cartes dans l'équipement électrique, d'une part, et de chaque équipement électronique sur l'étagère de la baie avionique, d'autre part.

La présente invention se combine avantageusement avec un système de refroidissement par air forcé ainsi qu'il est connu de l'état de la technique.

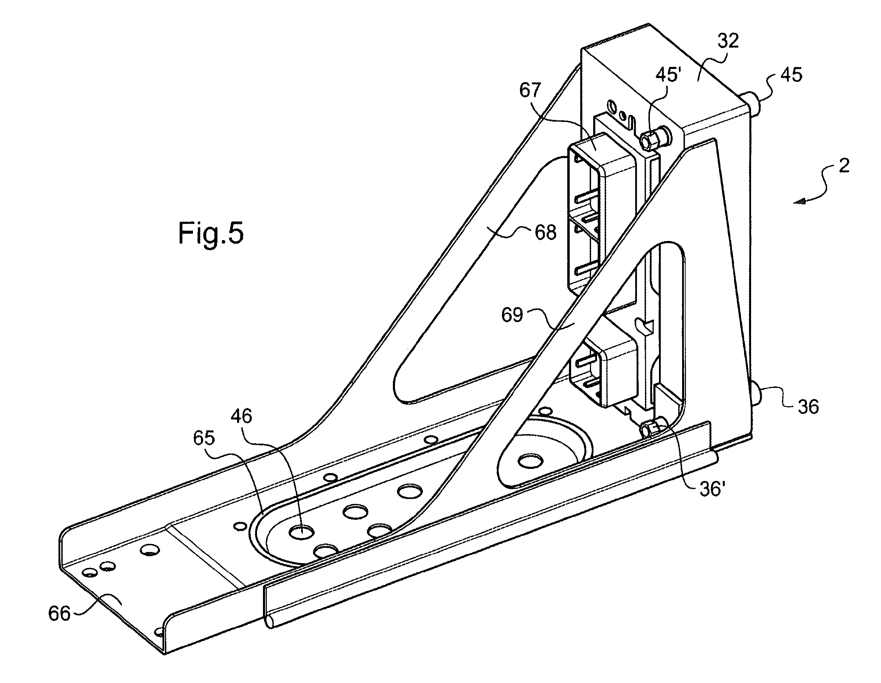

Dans un tel refroidissement forcé (Figure 5), la chaise d'adaptation électrique et mécanique 2 comporte une partie verticale formant le dossier 32, qui porte les raccords rapides 36 d'arrivée de fluide caloporteur, et 45 de sortie de fluide caloporteur ainsi que les raccords avec les raccords rapides du socle respectivement 36' et 45', ainsi que de la connectique avionique représentée en 67.

Une partie horizontale 66 formant assise de la chaise d'adaptation électrique et mécanique est solidarisée au dossier 32 notamment à l'aide des équerres 68 et 69 entre lesquelles vient s'insérer un équipement bâti autour d'un socle comme le socle 33, 33' (figures 3 et 4).

Dans ce mode de réalisation de la présente invention, la chaise présente, dans sa partie horizontale 66, une zone garnie de trous 46 entourée par un joint d'étanchéité aéraulique 65. La zone de trous 46 se trouve en relation fluidique avec une veine d'air circulant dans le profilé d'une étagère sur laquelle la chaise est montée (voir figures 1a et 1b).

Ainsi qu'il a été représenté à la figure 3, la partie horizontale 33' du socle de l'équipement électronique inséré dans la chaise est équipé de fentes 50 qui permettent, à l'intérieur du conditionnement de l'équipement, d'entrer en relation fluidique avec la zone des trous 46 de la chaise 2.

Par ailleurs, ainsi qu'il est représenté à la figure 4, le support porte-glissières est muni de trous 56 dont au moins certains se trouvent en relation avec les fentes, comme la fente 50 de la figure 3, sur la partie horizontale 33' du socle.

On ménage ainsi un flux d'air de refroidissement à travers ses différents orifices de sorte que de l'air peut s'échapper et baigner les plaques caloportrices des cartes électroniques insérées dans l'équipement électrique en fonctionnement. Grâce à cette disposition d'un refroidissement fluide apporté par les plaques de collecte de chaleur montées sur les circuits électroniques, il est possible d'assurer le maintien d'un refroidissement efficace de composants fortement dissipatifs lors de pannes de pressurisation de l'avion, ou de pannes totales de ventilation.

Le matériau choisi pour la plaque de collecte de chaleur est choisi parmi les matériaux de faible densité, pour minimiser la masse totale de la solution, et de forte conductivité et capacité thermiques, pour absorber et conduire avec un maximum d'efficacité le flux thermique dissipé vers le liquide de refroidissement des canaux. Le meilleur compromis en termes de choix de matériau est l'aluminium.

Les canaux sont pratiqués dans l'épaisseur de la plaque de collecte de chaleur selon un procédé classique et connu adapté aux zones de dissipation thermique de la carte électronique de fabrication par usinage. On réalise l'usinage des formes générales et des canaux de drainage. Les formes générales comprennent les évidements de matière dans les zones de la plaque collectrice où l'on ne souhaite pas échanger de flux thermique et les blocs, notamment disposés au droit des composants électroniques les plus dissipateurs de chaleur. Puis, la plaque est « fermée » par un capot et l'ensemble est rendu étanche par une soudure. La soudure est réalisée sur la jonction entre la plaque usinée et son couvercle après avoir installé les raccords rapides 39 et 42 (Figure 3).

## Revendications

1. Equipement électronique comportant un conditionnement (33, 33') et contenant au moins une carte électronique (35) dissipatrice de chaleur et connectée électriquement à un ensemble de fond de panier (52), l'équipement comporte au moins une entretoise (34 ; 51) solidaire du fond de panier (52) qui porte des raccords fluidiques rapides (37, 44) pour le raccord à un réseau de fluide de refroidissement (30, 31a, 31b) extérieur audit équipement, lesdits raccords fluidiques rapides (37, 44) étant accessibles de l'extérieur du conditionnement, et au moins un trajet (61-64) de collecte de chaleur sur ladite au moins une carte électronique (35) étant connecté fluidiquement auxdits raccords fluidiques rapides (37, 44), **caractérisé en ce que** la carte étant équipée d'au moins une plaque métallique collectrice de chaleur (61-65) qui porte des raccords fluidiques rapides (39, 42) de plaque, respectivement d'entrée et de sortie de fluide de refroidissement, qui se connectent avec lesdits raccords fluidiques rapides (37, 44) et établissent ainsi un circuit fluidique de refroidissement avec ledit réseau de fluide de refroidissement (30, 31 a, 31b).

2. Equipement selon la revendication 1, **caractérisé en ce que** ladite au moins une carte électronique (35) porte au moins une plaque collectrice de chaleur parcourue par des canaux de circulation de fluide (61 - 64) connectés par lesdits raccords fluidiques rapides (39, 42) de plaque à des raccords fluidiques rapides (38, 43) correspondants solidaires de ladite au moins une entretoise (34 ; 51), les raccords fluidiques rapides (38, 43) de ladite au moins une entretoise (34 ; 51) étant interconnectés par l'intermédiaire d'une chambre de distribution (70 - 72), ladite au moins une carte (35) pouvant être amovible sur la glissière (55) d'un support porte-glissières (49).

3. Equipement selon la revendication 2, **caractérisé en ce que** la plaque collectrice de chaleur comporte une plaque usinée de formes générales (61, 63) adaptées aux zones thermiques de la carte électronique et des canaux de circulation de fluide connectées auxdits raccords fluidiques rapides (39, 42) de plaque, la plaque usinée étant fermée par un couvercle dont la liaison à la plaque usinée est rendue étanche par une soudure.

4. Equipement selon la revendication 3, **caractérisé en ce que** la plaque usinée et/ou le couvercle sont réalisés en un matériau choisi parmi les matériaux de faible densité et de forte conductivité et capacité thermique, préférentiellement de l'aluminium.

5. Equipement selon l'une quelconque des revendications 2 à 4, **caractérisé en ce qu'**il comporte deux entretoises (34, 51) solidaires dudit ensemble de fond de panier (52) qui comporte au moins une carte mère comportant des connecteurs (C2) pour s'engager avec des connecteurs (C1) des cartes électroniques (35) et des connecteurs pour la connexion avec un réseau électrique extérieur à l'équipement, une première entretoise (34) étant disposée pour le circuit d'arrivée de fluide de refroidissement et une seconde entretoise (51) étant disposée pour le circuit de retour sur l'ensemble de fond de panier.

6. Baie avionique à refroidissement fluide pour équipement électronique amovible recevant au moins un équipement électronique selon l'une quelconque des revendications 1 à 5, **caractérisée en ce que** chaque équipement électronique est relié de manière amovible par un réseau de tubulures (31a, 31b) à au moins une source froide (30) d'un fluide de refroidissement.

7. Baie selon la revendication 6, du genre dans lequel au moins un équipement électronique est monté dans une chaise (32) d'adaptation mécanique et électrique, **caractérisée en ce que** la chaise (32) d'adaptation porte des premiers raccords fluidiques rapides (36, 45) pour se raccorder aux tubulures (31a, 31b) du réseau de fluide de refroidissement, et des seconds raccords rapides (36', 45') reliés auxdits premiers raccords fluidiques rapides (36, 45) et qui fournissent une connexion fluidique amovible avec les raccords fluidiques rapides (37, 44) de l'équipement électronique lorsqu'il est retiré ou inséré de sa chaise d'adaptation (32) dans la baie.

8. Baie selon la revendication 7, **caractérisée en ce qu'**au moins un équipement électronique comporte un support porte-glissières muni de fentes dans au moins un espace inter-glissières, ledit au moins un équipement électrique amovible étant entouré d'un conditionnement dont au moins une face parallèle au support porte-glissières est munie de passages d'air, le refroidissement fluidique des cartes à l'intérieur de l'équipement électrique amovible coopère avec un refroidissement par air forcé apporté par au moins une veine d'air circulant dans une étagère de la baie, la chaise d'adaptation mécanique et électrique, montée sur ladite étagère, comportant une zone de trous mettant en relation l'intérieur de l'équipement électrique avec ladite veine d'air à l'aide d'un joint qui limite une zone de pression entre la chaise et le support porte-glissières, établissant ainsi un flux d'air de refroidissement entre les cartes prélevé sur ladite veine d'air.

9. Baie selon l'une quelconque des revendications 6 à 8, **caractérisée en ce que** le fluide de refroidissement est de l'eau liquide.

10. Aéronef **caractérisé en ce qu'**il comporte au moins une baie avionique selon l'une quelconque des revendications 6 à 9.

## Patentansprüche

1. Elektronische Ausrüstung, die eine Abdeckung (33, 33') aufweist und mindestens eine Elektronikkarte (35) enthält, welche Wärme ableitet und elektrisch mit einer Hauptplatineneinheit (52) verbunden ist, wobei die Ausrüstung mindestens einen fest mit der Hauptplatine (52) verbundenen Querträger (34; 51) aufweist, der fluidische Schnellkupplungen (37, 44) für die Kupplung mit einem Kühlfluidnetz (30, 31a, 31b) außerhalb der Ausrüstung trägt, wobei die fluidischen Schnellkupplungen (37, 44) von außerhalb der Abdeckung zugänglich sind, und mindestens ein Wärmesammelpfad (61-64) auf der mindestens einen Elektronikkarte (35) mit den fluidischen Schnellkupplungen (37, 44) fluidisch verbunden ist, **dadurch gekennzeichnet, dass** die Karte mit mindestens einer metallischen Wärmesammelplatte (61-65) ausgestattet ist, die fluidische Platten-Schnellkupplungen (39, 42) für den Eintritt bzw. Austritt von Kühlfluid trägt, die sich mit den fluidischen Schnellkupplungen (37, 44) verbinden und so einen fluidischen Kühlkreislauf mit dem Kühlfluidnetz (30, 31a, 31b) aufbauen.

2. Ausrüstung nach Anspruch 1, **dadurch gekennzeichnet, dass** die mindestens eine Elektronikkarte (35) mindestens eine Wärmesammelplatte trägt, die von Fluidzirkulationskanälen (61-64) durchquert wird, welche durch die fluidischen Platten-Schnellkupplungen (39, 42) mit entsprechenden fluidischen Schnellkupplungen (38, 43) verbunden werden, die fest mit dem mindestens einen Querträger (34; 51) verbunden sind, wobei die fluidischen Schnellkupplungen (38, 43) des mindestens einen Querträgers (34; 51) mittels einer Verteilerkammer (70-72) miteinander verbunden sind, wobei die mindestens eine Karte (35) auf der Gleitschiene (55) eines Gleitschienenträgers (49) entfernbar sein kann.

3. Ausrüstung nach Anspruch 2, **dadurch gekennzeichnet, dass** die Wärmesammelplatte eine bearbeitete Platte allgemeiner Formen (61, 63), die an die Wärmebereiche der Elektronikkarte angepasst sind, und mit den fluidische Platten-Schnellkupplungen (39, 42) verbundene Fluidzirkulationskanäle aufweist, wobei die bearbeitete Platte von einem Deckel verschlossen wird, dessen Verbindung mit der bearbeiteten Platte durch eine Schweißnaht abgedichtet wird.

4. Ausrüstung nach Anspruch 3, **dadurch gekennzeichnet, dass** die bearbeitete Platte und/oder der Deckel aus einem Material hergestellt sind, das aus den Materialien geringer Dichte und großer Leitfähigkeit und Wärmekapazität ausgewählt wird, vorzugsweise Aluminium.

5. Ausrüstung nach einem der Ansprüche 2 bis 4, **dadurch gekennzeichnet, dass** sie zwei Querträger (34, 51) aufweist, die fest mit der Hauptplatineneinheit (52) verbunden sind, welche mindestens eine Mutterplatine aufweist, die Verbinder (C2), um mit Verbindern (C1) der Elektronikkarten (35) in Eingriff zu kommen, und Verbinder für die Verbindung mit einem Stromnetz außerhalb der Ausrüstung aufweist, wobei ein erster Querträger (34) für den Kühlfluid-Ankunftskreislauf und ein zweiter Querträger (51) für den Rückkreislauf zur Hauptplatineneinheit angeordnet ist.

6. Avionik-Rack mit Fluidkühlung für eine entfernbare elektronische Ausrüstung, das mindestens eine elektronische Ausrüstung nach einem der Ansprüche 1 bis 5 aufnimmt, **dadurch gekennzeichnet, dass** jede elektronische Ausrüstung durch ein Netz von Leitungen (31a, 31b) mit mindestens einer Kaltquelle (30) eines Kühlfluids entfernbar verbunden ist.

7. Rack nach Anspruch 6, von der Art, bei der mindestens eine elektronische Ausrüstung in ein Gestell (32) zur mechanischen und elektrischen Anpassung montiert ist, **dadurch gekennzeichnet, dass** das Anpassungsgestell (32) erste fluidische Schnellkupplungen (36, 45), um sich an die Leitungen (31a, 31b) des Kühlfluidnetzes anzuschließen, und zweite Schnellkupplungen (36', 45') aufweist, die mit den ersten fluidischen Schnellkupplungen (36, 45) verbunden sind und eine entfernbare fluidische Verbindung mit den fluidischen Schnellkupplungen (37, 44) der elektronischen Ausrüstung liefern, wenn sie aus ihren Anpassungsgestell (32) im Rack entnommen oder in dieses eingeführt wird.

8. Rack nach Anspruch 7, **dadurch gekennzeichnet, dass** mindestens eine elektronische Ausrüstung einen Gleitschienenträger aufweist, der in mindestens einem Gleitschienenzwischenraum mit Schlitzen versehen ist, wobei die mindestens eine entfernbare elektrische Ausrüstung von einer Abdeckung umgeben ist, von der mindestens eine Seite parallel zum Gleitschienenträger mit Luftdurchlässen versehen ist, die fluidische Kühlung der Karten im Inneren der entfernbaren elektrischen Ausrüstung mit einer Zwangsluftkühlung zusammenwirkt, die von mindestens einer Luftströmung zugeführt wird, die in einem Regal des Racks zirkuliert, wobei das Gestell zur mechanischen und elektrischen Anpassung, das auf das Regal montiert ist, einen Bereich von Löchern aufweist, die das Innere der elektrischen Ausrüstung mit der Luftströmung mit Hilfe einer Dichtung in Verbindung setzt, die einen Druckbereich zwischen dem Gestell und dem Gleitschienenträger begrenzt, wodurch ein Kühlluftstrom zwischen den Karten aufgebaut wird, der von der Luftströmung entnommen wird.

9. Rack nach einem der Ansprüche 6 bis 8, **dadurch gekennzeichnet, dass** das Kühlfluid flüssiges Wasser ist.

10. Luftfahrzeug, **dadurch gekennzeichnet, dass** es mindestens ein Avionik-Rack nach einem der Ansprüche 6 bis 9 aufweist.

## Claims

1. Electronic equipment comprising a packaging (33, 33') and containing at least one heat-dissipating electronic board (35) connected electrically to a backplane assembly (52), the equipment comprising at least one crosspiece (34; 51) joined to the backplane (52) which bears quick-disconnect fluidic couplings (37, 44) for coupling to a cooling fluid system (30, 31 a, 31 b) outside the said equipment, the said quick-disconnect couplings (37, 44) being accessible from the outside of the packaging, and at least one heat collector passage (61-64) on the said at least one electronic board (35) being fluidically connected to the said quick-disconnect couplings (37, 44), **characterized in that** the board is equipped with at least one metal heat collector plate (61-65) that bears plate quick-disconnect couplings (39, 42), respectively for intake and outtake of cooling fluid, which couple with said quick-disconnect couplings (37, 44) and thereby establish a cooling fluidic circuit with said cooling fluid system (30, 31 a, 31 b).

2. Equipment according to claim 1, **characterized in that** the said at least one electronic board (35) bears at least one heat collector plate traversed by fluid circulation channels (61-64) connected via said plate quick-disconnect fluidic couplings (39, 42) to corresponding quick-disconnect fluidic couplings (38, 43) joined to the said at least one crosspiece (34; 51), the quick-disconnect fluidic couplings (38, 43) of the said at least one crosspiece (34; 51) being interconnected via a distribution chamber (70-72), the said at least one board (35) being able to be removable on the slide (55) of a slide-holder support (49).

3. Equipment according to claim 2, **characterized in that** the heat collector plate comprises a machined plate of general forms (61, 63) adapted to the thermal zones of the electronic board and fluid circulation channels connected to the said plate quick-disconnect fluidic couplings (39, 42), the machined plate being closed by a cover the connection of which to the machined plate is made fluid-tight by a weld.

4. Equipment according to claim 3, **characterized in that** the machined plate and/or the cover are made of a material chosen from among materials with low density and high thermal capacity and conductivity, preferably aluminum.

5. Equipment according to any one of claims 2 to 4, **characterized in that** it comprises crosspieces (34, 51) joined to the said backplane (52) which comprises at least one mother-board comprising connectors (C2) for engaging with connectors (C1) of the electronic boards (35) and connectors for connection with an electrical system outside the equipment, a first crosspiece (34) being disposed for the cooling fluid intake circuit and a second crosspiece (51) being disposed for the return circuit on the backplane assembly.

6. Fluid-cooled avionic rack for removable electronic equipment receiving at least one electronic equipment item according to any one of claims 1 to 5, **characterized in that** each electronic equipment item is removably connected via a system of pipes (31 a, 31 b) to at least one cold source (30) for a cooling fluid.

7. Rack according to claim 6, of the type in which at least one electronic equipment item is mounted in a mechanical and electrical adaptation tray (32), **characterized in that** the adaptation tray (32) bears first quick-disconnect fluidic couplings (36, 45) for being connected to the pipes (31 a, 31 b) of the cooling fluid system, and second quick-disconnect couplings (36', 45') connected to the said first quick-disconnect fluidic couplings (36, 45) and which provide a removable fluidic connection with the quick-disconnect couplings (37, 44) of the electronic equipment when it is removed from or inserted into its adaptation tray (32) in the rack.

8. Rack according to claim 7, **characterized in that** at least one electronic equipment item comprises a slide-holder support equipped with slots in at least one inter-slide space, the said at least one removable electrical equipment item being surrounded by a packaging at least one face of which, parallel to the slide-holder support, is equipped with air passages, the fluidic cooling of the boards inside the removable electrical equipment cooperates with a forced-air cooling provided by at least one air jet circulating in a shelf of the rack, the mechanical and electrical adaptation tray, mounted on the said shelf, comprising a zone of holes placing the inside of the electrical equipment in contact with the said air jet with the aid of a joint that delimits a pressure zone between the tray and the slide-holder support, in this way establishing between the boards a flow of cooling air taken from the said air jet.

9. Rack according to any one of clams 6 to 8, **characterized in that** the cooling fluid is liquid water.

10. Aircraft **characterized in that** it comprises at least one avionic rack according to any one of claims 6 to 9.
